# EUROPÄISCHE PATENTSCHRIFT

(11) **EP 0 874 920 B1**
(45) Veröffentlichungstag und Bekanntmachung des Hinweises auf die Patenterteilung: **20.10.1999**
(21) Anmeldenummer: 97914313.8
(22) Anmeldetag: 26.03.1997
(51) Int. Cl.: C25D 5/02, C25F 3/14

(54) **VERFAHREN UND VORRICHTUNG ZUM ELEKTROCHEMISCHEN BEHANDELN VON BEHANDLUNGSGUT MIT EINER BEHANDLUNGSFLÜSSIGKEIT**
PROCESS AND DEVICE FOR THE ELECTROCHEMICAL TREATMENT OF ITEMS WITH A FLUID
PROCEDE ET DISPOSITIF POUR LE TRAITEMENT ELECTROCHIMIQUE DE PRODUITS AU MOYEN D'UN LIQUIDE DE TRAITEMENT

(30) Priorität: 29.03.1996 DE 19612555
(43) Veröffentlichungstag der Anmeldung: 04.11.1998
(73) Patentinhaber: ATOTECH Deutschland GmbH, 10553 Berlin (DE)
(72) Erfinder: SCHRÖDER, Rolf, D-90537 Feucht (DE); SCHNEIDER, Reinhard, D-90556 Cadolzburg (DE); KOPP, Lorenz, D-90518 Altdorf (DE); RYDLEWSKI, Thomas, D-90439 Nürnberg (DE); STEFFEN, Horst, D-47608 Geldern (DE)
(74) Vertreter: Effert, Bressel und Kollegen
(86) Internationale Anmeldenummer: EP9701544
(87) Internationale Veröffentlichungsnummer: WO9737062

(56) Entgegenhaltungen:
- US-A- 4 093 520
- US-A- 4 359 366
- PATENT ABSTRACTS OF JAPAN vol. 013, no. 134 (C-581), 4.April 1989 & JP 63 297588 A (SAGAMI SHOKAI:KK), 5.Dezember 1988,

## Beschreibung

Die Erfindung betrifft ein Verfahren zum elektrochemischen Behandeln von Behandungsgut mit einer Behandlungsflüssigkeit sowie eine Vorrichtung zur Durchführung des Verfahrens.

Zur Herstellung von Leiterplatten müssen an deren Oberflächen leitfähige Strukturen, die Leiterzüge, gebildet werden. Diese stellen gegenseitig isolierte Inseln dar, die selektiv zu behandeln sind.

Die Strukturen auf Behandlungsgut, beispielsweise auf Leiterplatten, müssen zur Behandlung jedoch jeweils eine elektrisch leitfähige Verbindung zur Badstromquelle aufweisen, da eine elektrochemische Behandlung von Behandlungsgut grundsätzlich voraussetzt, daß die zu behandelnden Oberflächen elektrisch leitfähig sind. Bei bekannten elektrochemischen Verfahren wird zur Behandlung von Strukturen auf Leiterplatten daher von einer vollflächig metallisierten und gegebenenfalls durchkontaktierten und elektrolytisch mit Kupfer verstärkten Leiterplatte ausgegangen. Auf die derartig vorbereiteten Leiterplatten werden die Strukturen durch Bedrucken oder auf photographischem Wege, zum Beispiel mit negativer Strukturabbildung, aufgebracht. Anschließend werden die nicht abgedeckten elektrisch leitfähigen Flächen selektiv elektrochemisch behandelt. In der Regel sind hierzu mehrere Prozeßschritte erforderlich. Zuletzt muß die elektrisch leitfähige Schicht zwischen den Strukturen durch Ätzen vollständig entfernt werden. Das Ätzverfahren wird vorzugsweise in chemischen Bädern unter Anwendung der Spritz- und Sprühtechnik durchgeführt.

Nachteilig bei diesem Verfahren ist, daß das Behandlungsgut zweimal in eine naßchemische Behandlungsstraße eingefahren werden muß: Zunächst werden die Leiterplatten durchkontaktiert. Danach werden die Platten außerhalb des Naßbereiches mit dem Strukturbild bedruckt und anschließend werden sie erneut zum Behandeln der Strukturen in eine naßchemische Behandlungsstraße eingefahren. Entsprechende Spül- und Trocknungsprozesse sind nötig. Ferner ist es nachteilig, daß die leitende Basisschicht zwischen den Strukturen erst nach Fertigstellung der Leiterzüge entfernt werden kann. Hierzu müssen die Oberflächen der Leiterzüge mit einem zusätzlichen Schutz versehen werden, um beim Ätzprozeß nicht beschädigt zu werden.

Ähnlich verhält es sich bei der Herstellung von Innenlagen von Multilayerschaltungen. Zur Vermeidung eines zweimaligen Einfahrens in naßchemische Behandlungsstraßen (elektrochemische vollflächige Behandlung der Oberfläche, Ausfahren, Bedrucken und anschließend Weiterbehandeln mit naßchemischen Methoden) können auch zuerst die unbehandelten vollflächigen Kupferoberflächen bedruckt werden. Danach werden das Ätzverfahren und die weitere selektive Oberflächenbehandlung auf chemischem Wege durchgeführt. Die verbleibenden Kupferoberflächen, die nach dem Ätzen elektrisch isolierte Inseln darstellen, werden zur Verbesserung der Haftfestigkeit beim Verpressen mehrerer derartiger Innenlagen mit bekannten Verfahren an den Oberflächen schwarz- oder braunoxidiert. Anschließend werden die Oberflächen zur Verbesserung der Korrosionseigenschaften chemisch reduziert. Diese chemischen Prozesse sind zeitaufwendig und infolge eines fortlaufenden hohen Chemikalienverbrauches und der Entsorgung großer Mengen verbrauchter Chemikalien sehr teuer. Im Gegensatz dazu weisen die elektrochemischen Verfahren zur Oxidation bzw. Reduktion der Kupferoberflächen im Vergleich zur rein chemischen Behandlung erhebliche Vorteile auf.

In der Offenlegungsschrift DE 43 37 988 A1 wird ein Verfahren zur Herstellung von Multilayer-lnnenlagen beschrieben. Es wird vorgeschlagen, die oxidierten Kupferoberflächen in einer horizontalen Durchlaufanlage elektrochemisch zu reduzieren. Als Elektrolyt soll beispielsweise eine Salzlösung eingesetzt werden. Über ein oder zwei Walzenpaare pro Multilayer-Lage werden die oxidierten Oberflächen mit kathodischer Polarität elektrisch kontaktiert, indem die Strukturen mit der Badstromquelle über die Walzen elektrisch verbunden werden. Die Anoden sind so angeordnet, daß das Behandlungsgut zwischen diesen hindurchtransportiert werden kann. Durch Elektrolyse entsteht an den kathodisch gepolten Flächen des Gutes Wasserstoff in atomarer Form, der das Kupferoxid reduziert. Der Aufwand hierfür ist im Vergleich zur chemischen Reduktion gering.

Nachteilig bei diesem Verfahren ist, daß die Kontaktzeit an den Walzen während des Durchlaufes sehr klein ist. Ein Leiterzug oder ein isoliertes Lötauge mit einer Abmessung von einem Millimeter in Transportrichtung der Leiterplatten wird bei einer Transportgeschwindigkeit von 1 m/min nur während des sehr kurzen Zeitraums von etwa 0,06 Sekunden kontaktiert. Diese kurze Zeitspanne ist zum elektrochemischen Behandeln jedoch viel zu gering. Andere Leiterzüge auf der Leiterfolie, die parallel zur Transportrichtung ausgerichtet sind, haben entsprechend ihrer Länge eine wesentlich größere Kontaktzeit. Die Folge ist, daß die wirksame Behandlungszeit von der Ausrichtung der Strukturen auf dem Behandlungsgut abhängig ist. Nachteilig ist ferner, daß die Kontaktwalzen sehr präzise ausgebildet sein müssen, um alle gegenseitig isolierten Kupferflächen entlang der Mantellinie zu kontaktieren und damit behandeln zu können. Bei kathodischer Schaltung der Walzen neigen diese des weiteren zur Anlagerung von Verunreinigungen, die teilweise sehr fest haften. Dadurch wird das gleichmäßige Kontaktieren des Behandlungsgutes weiter erschwert. Handelt es sich bei dem elektrochemischen Verfahren um ein Galvanisierverfahren, so werden die Walzen ebenfalls sehr stark metallisiert, so daß ein kontinuierlicher Dauerbetrieb mit diesem Verfahren nicht möglich ist.

Grundsätzlich ist die Walzenkontaktierung auch dann ungeeignet, wenn die Strukturen nur partiell elektrochemisch behandelt werden sollen. In diesem Falle sind die nicht zu behandelnden Flächen zum Beispiel mit Lötstopplack abgedeckt. Die dann tiefer liegenden zu behandelnden Flächen können von den Kontaktwalzen nicht erreicht werden.

Ein anderes Verfahren und eine hierfür geeignete Vorrichtung ist aus US-A 51 14 558 bekannt. In dieser Druckschrift ist eine Vorrichtung zur Herstellung feiner Leiterzüge auf Leiterplatten mit geringem Abstand voneinander beschrieben. Diese Vorrichtung enthält in einer Ausführungsform zur Kontaktierung der Leiterzüge eine Vielzahl von in zwei Ebenen angeordneten Bürstenfasern, die senkrecht zu einer Transportrichtung der Leiterplatten an beiden Seiten der Leiterplatten anliegen. Diese Bürsten sind mit einer Stromquelle verbunden und beim Ätzen der Strukturen aus ganzflächiger Kaschierung anodisch gepolt. Eine Gegenelektrode ist von der Leiterplattenebene aus gesehen jenseits der Bürstenanordnung vorgesehen, die ebenfalls mit der Stromquelle verbunden und in der gezeigten Anordnung kathodisch gepolt ist. Diese Vorrichtung ist jedoch nicht geeignet, mit ausreichend hohen Strömen eine elektrochemische Behandlung der metallischen Flächen an den Leiterplatten durchzuführen, da die Gegenelektrode durch die Bürsten vollständig abgeschirmt wird. Es ist sogar zu vermuten, daß mit dieser Anordnung an den Leiterplatten überhaupt kein elektrischer Strom erzeugt werden kann. Vielmehr spielen sich alle elektrochemischen Prozesse innerhalb eines Spaltes zwischen den Gegenelektroden und den Bürsten ab.

In der weiteren Druckschrift DE 41 23 985 C2 ist eine Vorrichtung zur elektrolytischen Behandlung von Leiterplatten, insbesondere zur elektrolytischen Beschichtung mit Kupfer, offenbart. Zur Lösung des dort beschriebenen Problems, daß sich üblicherweise elektrolytisch abgeschiedenes Metall an der Kontaktierungstelle zu den Leiterplatten bildet, wird ebenfalls vorgeschlagen, Bürsten zur Kontaktierung der Leiterplatten zu verwenden. Diese werden auf den Rand der Leiterplattenoberflächen aufgesetzt, um einen elektrischen Kontakt zwischen der Stromquelle und der mit ganzflächigen Metallschichten überzogenen Leiterplatte zu bilden. Allerdings besteht mit dieser Vorrichtung nicht die Möglichkeit, auch elektrisch voneinander isolierte metallische Bereiche auf Leiterplattenoberflächen zu kontaktieren.

In PATENT ABSTRACTS OF JAPAN, vol. 013, no. 134 (C-581) ist eine Vorrichtung offenbart, bei der Leiterplatten durch einen mit einem Metallisierungsbad gefüllten Metallisierungsbehälter hindurchgeführt und mit einer als rotierende Bürstenwalze ausgebildeten Elektrode in Kontakt gebracht werden, um auf den Leiterplatten angeordnete, isolierte elektrische Leiter elektrolytisch zu metallisieren. Die Vorrichtung enthält eine als Platte ausgebildete Gegenelektrode, die neben der rotierenden Bürstenwalze und der Leiterplatte gegenüberliegend angeordnet ist.

Der vorliegenden Erfindung liegt von daher das Problem zugrunde. die Nachteile des Standes der Technik zu vermeiden und insbesondere ein geeignetes Verfahren und eine Vorrichtung zum elektrochemischen Behandeln von elektrisch gegeneinander isolierten elektrisch leitfähigen Bereichen auf Behandungsgut, insbesondere auf Leiterplatten, mittels einer Behandlungsflüssigkeit bereitzustellen. Vor allem sollen das Verfahren und die Vorrichtung dazu geeignet sein, die Leiterplatten in Durchlaufanlagen, in denen die Leiterplatten in horizontaler oder vertikaler Lage gehalten werden, zu behandeln und eine Behandlung von Strukturen, die aus sehr kleinen isolierten Flächen bestehen, und/oder nur eine partielle Behandlung von elektrisch leitfähigen Strukturen zu ermöglichen. Ein wesentlicher Aspekt der Erfndung betrifft ferner das Problem, daß sich auf Kontaktierelementen bei der elektrolytischen Metallabscheidung das Metall auch auf den Kontaktierelementen niederschlägt, so daß geeignete Maßnahmen getroffen werden müssen, um auch dieses Problem zu lösen.

Gelöst werden diese Probleme durch die Gegenstände der Ansprüche 1 und 10. Bevorzugte Ausführungsformen der Erfindung sind in den Unteransprüchen angegeben.

Mit dem erfindungsmäßen Verfahren und der Vorrichtung kann Behandlungsgut mittels geeigneter Transporteinrichtungen auf einer Transportbahn durch die Vorrichtung befördert werden. Ferner sind weitere geeignete Einrichtungen zum Führen oder Aufnehmen der Behandlungsflüssigkeit vorgesehen, die so angeordnet sind, daß das Gut beim Befördern durch die Vorrichtung mit der Behandlungsflüssigkeit zumindest zeitweise in Kontakt gebracht wird, beispielsweise durch Eintauchen oder Beschwallen. Es werden alle elektrisch gegeneinander isolierten elektrisch leitfähigen Bereiche auf dem Behandlungsgut, beispielsweise den Leiterplatten, mit stationären, von einer Stromquelle über elektrische Verbindungen gespeisten Bürstenelektroden zumindest nacheinander in Kontakt gebracht, so daß an den Bereichen ein elektrisches Potential anliegt, während die Bereiche mit der Behandlungsflüssigkeit in Kontakt stehen. Ferner sind ebenfalls in der Nähe der Transportbahn angeordnete und von der Stromquelle über elektrische Verbindungen mit umgekehrter Polarität gespeiste Gegenelektroden vorgesehen und so angeordnet, daß ein elektrischer Strom zwischen den Bereichen und den Gegenelektroden fließen kann. Dadurch wird gewährleistet, daß alle elektrisch leitfähigen Bereiche bei gleichzeitigem Kontakt mit dem flüssigen Behandlungsmittel nacheinander elektrochemisch behandelt werden. Mit dem Verfahren und der Vorrichtung ist es auch möglich, sehr kleine elektrisch leitfähige Bereiche nur partiell zu behandeln. Ferner ist vorgesehen, bei der elektrochemischen Behandlung auf den Bürstenelektroden abgeschiedenes Metall von angelagertem Metall wieder zu befreien.

Ferner sind zwischen den Bürstenelektroden und den Gegenelektroden jeweils elektrisch isolierende Trennmittel angeordnet, um einen direkten Stromfluß zwischen den Gegenelektroden und den Bürstenelektroden zu verhindern.

Eine bevorzugte Anwendung des erfindungsgemäßen Verfahrens bzw. bevorzugte Ausführungsform der Vorrichtung besteht darin, Leiterplatten in kontinuierlicher Weise in einer Durchlaufanlage zu behandeln. Hierzu werden die Platten mittels geeigneter Transporteinrichtungen, beispielsweise Walzen oder Rädern, in horizontaler Transportrichtung durch die Anlage befördert und gelangen dabei beispielsweise in ein Bad der Behandlungsflüssigkeit oder werden durch geeignete Einrichtungen beschwallt oder besprüht. Die Leiterplatten können dabei horizontal oder vertikal gelagert sein. Die Bürstenelektroden und Gegenelektroden zur elektrochemischen Behandlung befinden sich vorzugsweise an beiden Seiten der Transportbahn, d.h. beispielsweise oberhalb und unterhalb der Transportebene. Daher werden die Platten zwischen den Elektroden hindurchbefördert. Die Elektroden können natürlich auch ausschließlich auf einer Seite der Leiterplatten angeordnet sein. Um eine optimale Verteilung der elektrischen Feldlinien in dem Raum zwischen den Elektroden und der Transportbahn zu erreichen, werden die Bürstenelektroden und die Gegenelektroden in der Nähe der Transportbahn in Transportrichtung oder einer anderen Richtung gesehen vorzugsweise abwechselnd angeordnet, so daß die Gegenelektroden zwischen den auf einer Seite des Behandlungsgutes nebeneinanderliegend angeordneten Bürstenelektroden angeordnet sind.

Die Bürsten bestehen aus feindrähtigen, elektrisch leitfähigen Fasern. Sie werden vorzugsweise innerhalb der Behandlungsflüssigkeit unter dem Badspiegel angeordnet und sind bevorzugt in Form von parallel zueinander ausgerichteten Reihen ausgebildet. Diese Reihen können in einem Winkel größer als Null zur Transportrichtung des Behandlungsgutes, vorzugsweise senkrecht zur Transportrichtung, und parallel zu der vorzugsweise in Form einer Transportebene ausgebildeten Transportbahn angeordnet sein.

Zum Schutz gegen chemische und elektrochemische Angriffe bestehen die Bürsten aus resistenten Werkstoffen wie zum Beispiel Titan, Niob, Tantal, Edelmetallen oder Edelstahl. Die Fasern der Bürste, zum Beispiel mit einem Faserdurchmesser von 0,01 mm, sind sehr elastisch. Sie passen sich der zu behandelnden Oberfläche sehr gut an. Dies ermöglicht auch die partielle Behandlung von Strukturen, die tiefer liegen als isolierende Schichten neben diesen Bereichen (beispielsweise einem Lötstopplack). Die Faserbüschel erreichen auch kleinste Flächenbereiche zwischen diesen Isolationen. Die feindrähtigen Fasern verursachen auf den zu behandelnden Oberflächen infolge ihrer Elastizität keine Beschädigungen. In Verbindung mit einer großen Anzahl von Fasern je Bürste ergibt sich bei entsprechender Anordnung von vielen Bürsten quer zur Transportrichtung des Behandlungsgutes eine lange Kontaktzeit der einzelnen Strukturen. Entsprechend lang ist auch die elektrochemische Behandlung. Bei elektrochemischen Prozessen, bei denen kein Metall abgeschieden wird, kann die Kontaktzeit nahezu 100 Prozent erreichen, weil die Gegenelektroden dicht neben den Bürsten angeordnet werden können. Das bedeutet, daß jede isolierte Struktur während des Durchlaufes durch das elektrochemische Bad trotz der durch die Gegenelektroden bedingten Abstände der Bürstenelektroden voneinander stets im elektrischen Kontakt mit der Badstromquelle steht. Derartige elektrochemischen Prozesse sind zum Beispiel das elektrolytische Reinigen, Oxidieren, Reduzieren und Ätzen (Entgraten). Je nach eingesetztem Verfahren werden die Bürsten und über diese das Behandlungsgut anodisch oder kathodisch gepolt.

Das erfindungsgemäße Verfahren eignet sich insbesondere auch für solche elektrochemischen Prozesse, bei denen Metalle auf dem Behandlungsgut abgeschieden werden. Beispiele hierfür sind das selektive Abscheiden von Kupfer, Gold, Nickel, Zinn sowie Zinn/Blei-, Kupfer/Zinn- und Kupfer/Zink-Legierungen auf strukturierte Leiterplatten. Ferner eignen sich das Verfahren und die Vorrichtung auch zur volladditiven Herstellung von Leiterplatten durch elektrochemische Metallabscheidung, insbesondere durch Kupferabscheidung. Bei der elektrolytischen Metallabscheidung sind die Bürsten-) elektroden kathodisch geschaltet. Dies bedeutet, daß die elektrisch nicht isolierten Oberflächenbereiche der Bürsten, wie auch das Behandlungsgut selbst, galvanisiert werden. Daher müssen sie von Zeit zu Zeit entmetallisiert werden. Zur weitgehenden Vermeidung der Fasergalvanisierung kann jede Einzelfaser wie ein isolierter Feindraht mit einer Isolation versehen sein. Zur Erhaltung der Elastizität der Faser und wegen der geringen Abmessungen sind Lackisolationen und resistente Passivschichten aus Oxiden der verwendeten Metalle sowie mittels Elektrotauchlackierung aufgebrachte Schichten besonders geeignet. Nur die kontaktgebende Spitze der Faser ist in diesem Fall von der Isolation nicht bedeckt. Als Anoden können sowohl beim Abscheideprozeß lösliche als auch unlösliche Elektroden verwendet werden. Unlösliche Anoden haben den Vorteil. daß sie sich den konstruktiven Gegebenheiten der Anlage besser anpassen lassen.

Bei Verfahren, bei denen Metall auf den elektrisch leitfähigen Bereichen abgeschieden wird, müssen die Bürstenelektroden regelmäßig vom Metall wieder befreit werden. In einer Ausführungsform werden die Bürsten aus der Vorrichtung entfernt und in einer separaten Vorrichtung durch chemisches oder elektrochemisches Abätzen von angelagertem Metall befreit. Hierzu müssen die Bürstenelektroden so ausgebildet sein, daß sie leicht austauschbar sind. Durch zyklischen Austausch der Bürsten durch von Metall befreite Bürsten und Entmetallisierung der zu regenerierenden Bürsten in getrennten Bädern kann ein fortlaufender Betrieb der Durchlaufanlage aufrechterhalten werden.

In einer anderen Ausführungsform der Erfindung werden die kathodisch polarisierten Bürstenelektroden elektrochemisch in dem Galvanisierbad selbst entmetallisiert. In diesem Falle wird mit unlöslichen Anoden gearbeitet. Mindestens zwei in Form von vorzugsweise parallel angeordneten Reihen der Bürstenelektroden sind quer oder in einem beliebigen Winkel zur Transportrichtung der Leiterplatten angeordnet. Vorzugsweise erstrecken sich diese Reihen über die gesamte Breite der Transportbahn bzw. der von dem Behandlungsgut in Anspruch genommenen Breite oder zumindest über die Breite, die von den elektrisch leitfähigen Bereichen überstrichen wird. Zur Entmetallisierung werden einzelne der Bürstenelektroden oder Bürstenelektrodenreihen mittels geeigneter Einrichtungen von den Leiterplattenoberflächen abgehoben, indem ein Abstand zwischen den Elektroden und der Transportbahn hergestellt wird, so daß sie zu den Leiterplatten keinen Kontakt mehr haben. Dabei werden die Bürstenelektroden mittels weiterer geeigneter Einrichtungen zumindest zeitweise elektrisch umgepolt. Dadurch wirkt ein Teil der Bürstenelektroden beispielsweise beim Metallisieren als kathodische Kontaktierung für die Leiterplatten und der andere Teil als unlösliche Anoden. Des weiteren sind die umgepolten Bürstenelektroden in diesem Zustand auch anodisch gegenüber den anderen Bürsten gepolt. Die abgehobenen Bürsten werden elektrochemisch entmetallisiert, die anderen Bürsten führen das Kathodenpotential an die Oberflächen der zu behandelnden Strukturen. Diese Strukturen und die letztgenannten Bürsten werden metallisiert. Nach einer vorwählbaren Zeit werden die Schaltzustände der Bürsten gewechselt. Die metallisierten Bürsten werden als Anoden geschaltet, und die entmetallisierten Bürsten werden als Kathoden geschaltet. Entsprechend wird entmetallisiert und metallisiert. Das beschriebene Wechselspiel der Bürsten kann abwechselnd mit vielen Bürstenreihen in der Anlage erfolgen, so daß eine lange effektive kathodische Kontaktierzeit erzielt wird.

Die abgeschiedene Metallmenge auf den Leiterplattenoberflächen muß in dem Bad fortlaufend ergänzt werden. Dies geschieht mit bekannten Mitteln und Methoden, zum Beispiel durch Zugabe von Metallsalzen.

In einer weiteren Verfahrensvariante können die Bürstenelektroden auch mittels eines Entmetallisierungssubstrats, vorzugsweise in Form einer Platte, die ebenso wie das Behandlungsgut auf der Transportbahn durch die Anlage transportiert wird, von angelagertem Metall befreit werden. Diejenigen Bürstenelektroden oder Bürstenelektrodenreihen, an denen diese Platte vorbeitransportiert wird, werden durch geeignete Einrichtungen individuell von der Plattenoberfläche abgehoben und durch Umpolen anodisch geschaltet. Zur Steuerung dieses Ablaufes dient eine weitere Einrichtung, mit der der Transport des Substrats in der Vorrichtung verfolgt werden kann. Je nach dem jeweiligen Ort, an dem sich das Substrat befindet, werden die Einrichtungen zum Abheben und Umpolen der Bürstenelektroden angesteuert. Die Platte selbst ist vorzugsweise kathodisch geschaltet. Auf ihr wird das von den Bürsten elektrolytisch abgelöste Metall abgeschieden. Während eine Stromquelle zur Metallisierung der Leiterplatten dient und mit den Bürstenelektroden verbunden ist, die elektrischen Kontakt zu den Leiterplatten haben, kann eine weitere Stromquelle zur Entmetallisierung der umgepolten und von den Leiterplatten abgehobenen Bürstenelektroden vorgesehen sein. Dadurch kann der Strom für die Entmetallisierung unabhängig vom Entmetallisierungsstrom eingestellt werden. Insbesondere kann an den umgepolten Bürstenelektroden eine höhere Stromdichte eingestellt werden als an den Bürstenelektroden, die mit den Leiterplatten in Kontakt stehen.

Die Bürstenelektroden müssen dagegen nicht von der Transportebene abgehoben werden, wenn das Entmetallisierungssubstrat mit einem Diaphragma überzogen ist, das einen elektrischen Kurzschluß der Badstromquelle verhindert. Auch in diesem Fall werden diejenigen Bürstenelektroden, die vorzugsweise in Form von Reihen ausgebildet sind, zum Entfernen von angelagertem Metall vom Behandlungsgut, insbesondere den Leiterplatten, elektrisch umgepolt, an denen das Entmetallisierungssubstrat vorbeitransportiert wird.

Vorzugsweise kann das Entmetallisierungssubstrat auf einer Endlosbahn in der Vorrichtung befördert werden. Auf einem Teil der Bahn dient das Substrat zur Entmetallisierung der Bürstenelektroden in der angegebenen Weise. Auf einem anderen Teil der Bahn, vorzugsweise auf dem Rückweg zum Ausgangspunkt des ersten Teils der Bahn, wird das Entmetallisierungssubstrat selbst wieder entweder chemisch oder elektrochemisch von dem abgeschiedenen Metall befreit, indem es in ein geeignetes Entmetallisierungsbad, gegebenenfalls mit weiteren Elektroden zur elektrochemischen Entmetallisierung, eintaucht.

Anhand der schematischen Figuren 1 bis 3 werden das Verfahren und die Vorrichtung erläutert.
- Figur 1:: Vorrichtung mit austauschbarer Bürstenleiste mit dazwischenliegender Gegenelektrode;
- Figur 2:: Vorrichtung mit beweglicher Bürstenelektrodenanordnung zur Metallisierung und Entmetallisierung in der Galvanisierzelle;
- Figur 3:: Vorrichtung mit beweglicher Bürstenelektrodenanordnung und Entmetallisierungsplatte.

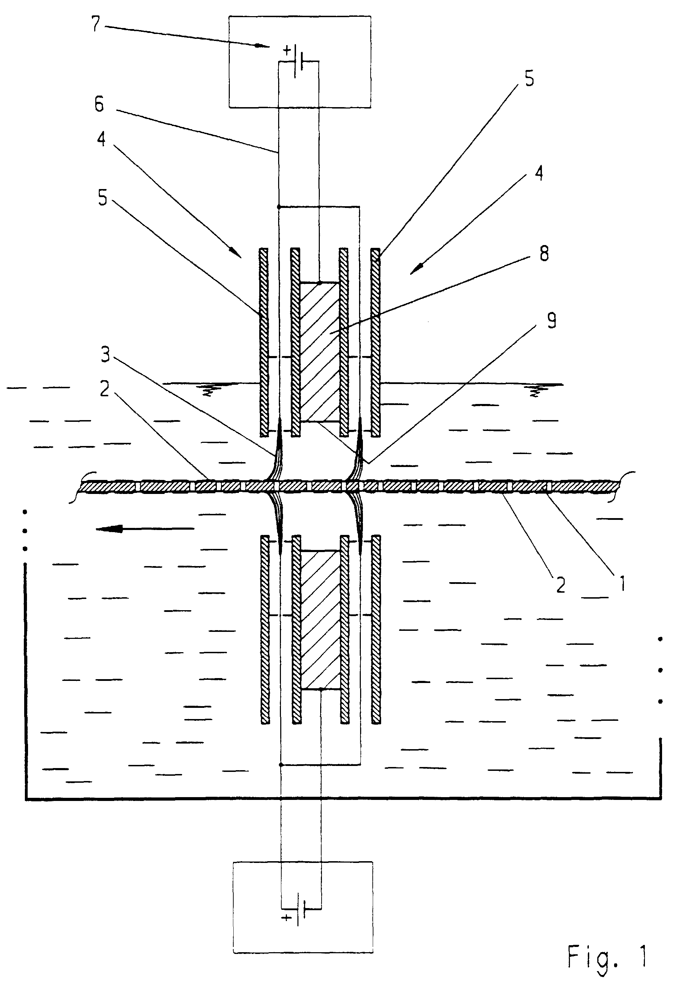

In Figur 1 befinden sich auf der Leiterplatte 1 beidseitig Strukturen 2, die elektrochemisch behandelt, hier galvanisiert, werden sollen. Die Strukturen sind elektrisch leitfähig. Sie können zum Beispiel durch Ätzen entstanden sein und haben keine elektrische Verbindung untereinander. Somit ist ein Kontaktieren der Strukturen an einer einzigen Stelle der Leiterplatte, wie es von den bekannten Verfahren zur Leiterplattenherstellung her üblich ist, nicht möglich. Zur Kontaktierung der Strukturen 2 in der vorliegenden Vorrichtung dienen die metallischen Fasern 3 der Bürsten 4. Die Fasern 3 liegen auf den zu behandelnden Oberflächen der Strukturen 2 leicht auf. Sie stellen somit zusammen mit den Leitungen 6 die elektrische Verbindung von den Oberflächen über die Bürsten 4 zur Badstromquelle 7 her. Der andere Pol der Badstromquelle 7 ist mit der Gegenelektrode 8 verbunden. Diese Elektrode befindet sich elektrisch isoliert zwischen den Bürsten 4. Die aktive Elektrodenfläche 9 befindet sich in der Nähe der elektrisch kontaktierten Strukturen 2. In Figur 1 ist die Badstromquelle 7 so gepolt dargestellt, daß sich die Vorrichtung zum Beispiel zum elektrochemischen Entmetallisieren der Leiterplatten eignet. Von Zeit zu Zeit ist die Gegenelektrode 8 zu entmetallisieren. Dies kann durch zyklischen Elektrodenaustausch erfolgen, indem die Elektroden der Vorrichtung entnommen und in einer separaten Vorrichtung entmetallisiert werden. Beim elektrochemischen Reduzieren ohne gelöstes Metall in der Behandlungslösung entfällt der Austausch der Bürsten, weil auf ihnen nichts abgeschieden wird.

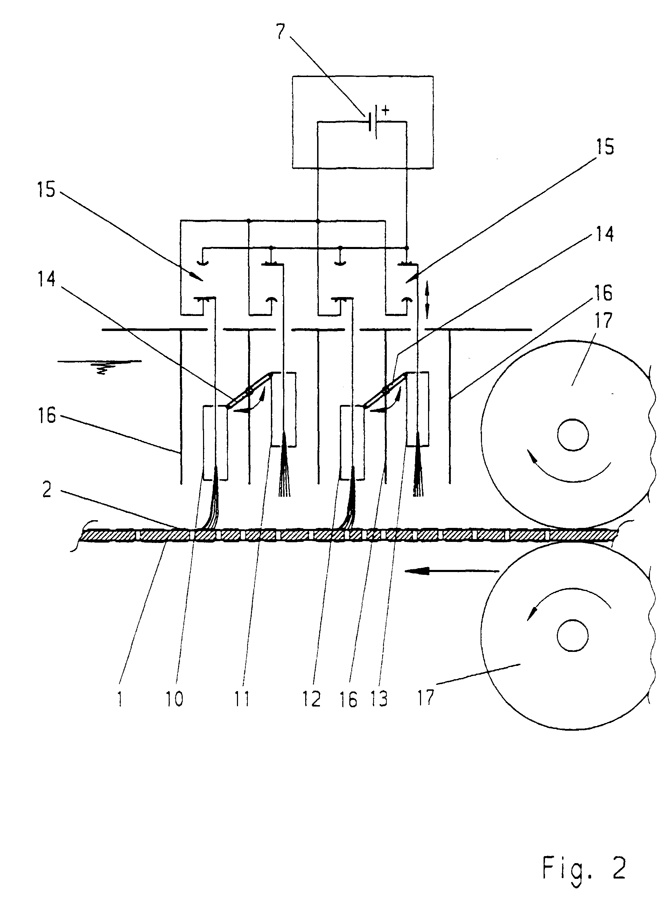

In Figur 2 sind die Bürsten 10, 11, 12, 13 beweglich angeordnet. Jeweils zwei Bürsten werden von einer Wippe 14 getragen. Die vorzugsweise stromgeregelte Badstromquelle 7 ist hier für die Bürsten 10 und 12 so gepolt, wie es zum Galvanisieren nötig ist. Die Bürsten 10 und 12 haben über den Umschalter 15 daher kathodisches Potential. Über sie werden die Strukturen 2 auf der Leiterplatte elektrisch kontaktiert. Die durch die Wippe 14 abgehobenen Bürsten 11 und 13 sind über den Umschalter 15 anodisch gepolt. Sie wirken als Anoden. Zugleich werden sie entmetallisiert, wenn sie zuvor galvanisiert wurden. Zur Fokusierung des Metallisierungs- und Entmetallisierungsvorganges auf die Leiterplatte und auf die Fasern der Bürsten befindet sich zwischen jeweils zwei Bürsten eine Trennwand 16, die elektrisch isolierend wirkt, so daß ein direkter Stromfluß zwischen den unterschiedlich gepolten Bürstenelektroden weitgehend verhindert wird.

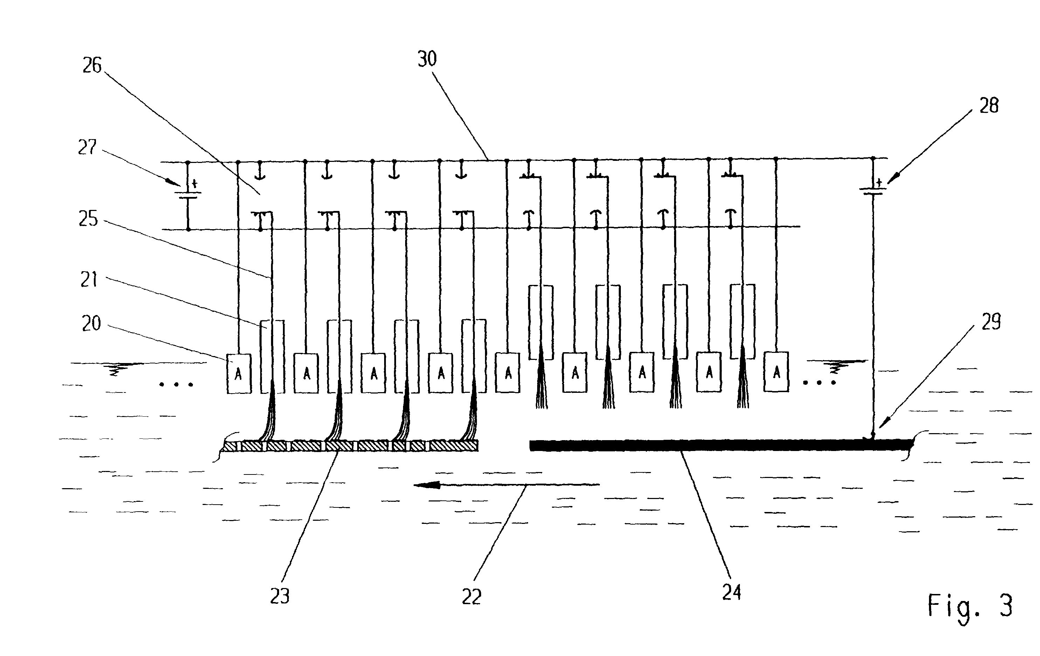

Nach Abschluß der Entmetallisierung der Bürsten 11 und 13 werden diese mittels der Wippen 14 an die Leiterplattenoberfläche gebracht, während gleichzeitig die Bürsten 10 und 12 von der Oberfläche abgehoben werden. Die Polarität der Bürsten ändert sich dabei entsprechend der Darstellung. In der Praxis können die Bürsten vorzugsweise in geringerem Abstand angeordnet werden, als es in Figur 2 dargestellt ist. Das Heben und Senken der Bürsten kann auch mit anderen mechanischen Mitteln erfolgen. Es beschränkt sich nicht auf Wippen. Das Umschalten der Polaritäten der Bürsten ist auch mit elektronischen Schaltern realisierbar. Die von Durchlaufanlagen bekannten Transportwalzen oder -räder 17 sind nur in Figur 2 dargestellt. Derartige Transportorgane können auch in den Vorrichtungen der Figuren 1 und 3 eingesetzt werden, um die Leiterplatten entlang der durch den dargestellten Pfeil gekennzeichneten Transportrichtung durch die Vorrichtung zu befördern. Darüber hinaus können Walzen auch dazu genutzt werden, um oberhalb der Transportebene befindliche Behandlungsflüssigkeit am Einlauf in die und am Auslauf aus der Vorrichtung daran zu hindern auszutreten.

In Figur 3 ist eine weitere Ausführungform der Erfindung gezeigt. In Durchlaufrichtung des Behandlungsgutes sind abwechselnd Anoden 20 und Bürsten 21 angeordnet. Sie erstrecken sich quer zur Transportrichtung, die mit dem Pfeil 22 angedeutet ist, über die gesamte Anlage, so daß alle auf den Leiterplatten vorhandenen Strukturen an den Bürsten- und Gegenelektroden vorbeibefördert werden. Die Bürstenelektroden 21 sind beweglich. Sie können durch einen nicht dargestellten Antrieb individuell von der zu behandelnden Leiterplatte 23 beziehungsweise von einer metallischen Entmetallisierungsplatte 24 abgehoben werden. Über der durchlaufenden Platte 24 sind die Bürsten 21 abgehoben. Auf der Leiterplatte 23 aufliegende Fasern der Bürsten stellen die elektrische Verbindung von den zu behandelnden Strukturen über Leitungen 25 zum Umschalter 26 her. Über ihn ist der Minuspol der Badstromquelle 27 momentan mit den galvanisierenden Bürsten verbunden. Der Galvanisierstrom wird automatisch entsprechend der gewählten Stromdichte in Abhängigkeit von der Anzahl der jeweils kathodisch geschalteten Bürsten eingestellt. Hierzu werden das Behandlungsgut, die Leiterplatte 23 beziehungsweise die Leiterplatten vom Steuerungssystem der Durchlaufanlage verfolgt. Das Zu- und Abschalten der Bürsten geschieht individuell in zeitlich richtiger Reihenfolge. Die Bürsten können in analoger Weise so, wie es in der Patentschrift DE 39 39 681 C2 zum Schalten von Anoden in Durchlaufanlagen beschrieben ist, geschaltet werden. Hinsichtlich der Art und der Durchführung dieser Steuerung wird auf diese Druckschrift verwiesen.

Die Anoden 20 sind vorzugsweise unlöslich. Das im Elektrolyten gelöste Metall wird nicht nur auf den Strukturen der Leiterplatte 23, sondern auch auf den Fasern beziehungsweise Faserspitzen der Bürsten abgeschieden. Sie müssen von Zeit zu Zeit entmetallisiert werden. In Figur 3 ist der Übergang von der Metallisierung zur Entmetallisierung dargestellt. Zur Entmetallisierung werden die Bürsten 21 angehoben und zugleich über Umschalter 26 an ein anodisches Potential gelegt. Zum Entmetallisieren dient die individuell einstellbare zweite Stromquelle 28. Der Minuspol der Stromquelle 28 ist mit der Entmetallisierungsplatte 24 elektrisch verbunden. Zur Kontaktierung der wie die Leiterplatten durch die Anlage zu transportierenden Entmetallisierungsplatten 24 dienen Schleifkontakte 29 oder Klammern, wie sie von horizontalen Galvanisier-Durchlaufanlagen bekannt sind.

Auf den Entmetallisierungsplatten 24 scheidet sich das Metall, das sich auf den Fasern der Bürsten befindet, nieder. Die Bürsten arbeiten praktisch bis zur vollständigen Metallablösung als lösliche Anoden, die zur Metallauflösung eine um etwa 0,8 Volt geringere Badspannung als unlösliche Anoden erfordern. Daraus ergibt sich, daß die unlöslichen Anoden 20 wegen des für sie zu niedrigen Potentiales nicht anspringen und keinen Galvanisierstrom führen. Nach vollständiger Ablösung des Metalles von den Fasern stellen diese ebenfalls unlösliche Anoden dar. Der Anodenstrom sinkt dann auf Werte von etwa Null ab. Dieser Umstand kann zur Einleitung der Umsteuerung der Bürsten genutzt werden. Werden lösliche Anoden 20 verwendet, so ist es zweckmäßig, diese elektrisch mittels eines nicht gezeichneten Schalters vom positiven Potential der Schiene 30 zu trennen, wenn in diesem Bereich gerade entmetallisiert wird.

Die Entmetallisierungsplatte 24 und die Schleifkontakte 29 oder Klammern können im Rücklauf zur Anlagenbeschickung chemisch oder elektrochemisch entmetallisiert werden. Die Platten können auch einer anderweitigen Metallrückgewinnung zugeführt werden.

In einer besonderen Ausgestaltung der Erfindung kann auf das Abheben der Bürsten 21 beim Entmetallisieren verzichtet werden. Zur Vermeidung eines Kurzschlusses der Badstromquelle 28 wird die Entmetallisierungsplatte 24 allseitig mit einem dünnen, elektrisch nichtleitenden Diaphragma bespannt. Ausgenommen hiervon sind nur die seitlichen Bereiche zur Kontaktierung der Platte. Diese Bereiche werden von den Bürsten nicht erfaßt. Das Diaphragma kann ein chemisch resistentes Tuch sein. Geeignet hierfür ist zum Beispiel ein Gewebe aus Polypropylen. Die anodisch geschalteten Bürsten werden über das Diaphragma entmetallisiert. Der Entmetallisierungsprozeß ist wegen des besonders geringen Anoden-/Kathodenabstandes hochwirksam. Dies erlaubt es, die Länge der momentanen Entmetallisierungsstrecke im Vergleich zur Metallisierungsstrecke kurz zu halten. Die mit dem Diaphragma bespannten Entmetallisierungsplatten werden ebenfalls durch das Diaphragma hindurch in einem separaten Teil der Transportbahn entmetallisiert. Vorzugsweise kann diese Entmetallisierung auch elektrochemisch durchgeführt werden.

Zur beidseitigen Behandlung der Leiterplatten kann auch die Vorrichtung der Figur 3 spiegelbildlich aufgebaut sein.

## Patentansprüche

1. Verfahren zum elektrochemischen Behandeln von elektrisch gegeneinander isolierten elektrisch leitfähigen Bereichen auf Behandlungsgut mittels einer Behandlungsflüssigkeit, bei dem
a. das Behandlungsgut mittels Transporteinrichtungen auf einer Transportbahn durch die Vorrichtung befördert und dabei mit der Behandlungsflüssigkeit zumindest zeitweise in Kontakt gebracht wird,
b. alle elektrisch leitfähigen Bereiche auf dem Behandlungsgut mit stationären, von einer Stromquelle gespeisten Bürstenelektroden zumindest nacheinander in Kontakt gebracht werden, so daß ein elektrisches Potential an den elektrisch leitfähigen Bereichen anliegt, während sich die Bereiche auch im Kontakt mit der Behandlungsflüssigkeit befinden,
c. bei dem ferner ebenfalls von der Stromquelle mit umgekehrter Polarität gespeiste Gegenelektroden in der Nähe der Transportbahn vorgesehen und so angeordnet werden, daß ein elektrischer Strom zwischen den elektrisch leitfähigen Bereichen und den Gegenelektroden fließen kann,
dadurch gekennzeichnet, daß
d. zwischen den Bürstenelektroden und den Gegenelektroden jeweils elektrisch isolierende Trennmittel angeordnet werden, um einen direkten Stromfluß zwischen den Gegenelektroden und den Bürstenelektroden zu verhindern.

2. Verfahren nach Anspruch 1, dadurch gekennzeichnet, daß die Bürstenelektroden von bei der Behandlung angelagertem Metall wieder befreit werden.

3. Verfahren nach Anspruch 2, dadurch gekennzeichnet, daß zum Entfernen von angelagertem Metall einzelne Bürstenelektroden von der Transportbahn abgehoben und dabei elektrisch umgepolt werden.

4. Verfahren nach Anspruch 3, dadurch gekennzeichnet, daß ein Entmetallisierungssubstrat auf der Transportbahn durch die Vorrichtung transportiert wird und ein Abstand zwischen der Transportbahn und denjenigen Bürstenelektroden hergestellt wird und dabei diejenigen Bürstenelektroden umgepolt werden, an denen das Entmetallisierungssubstrat vorbeitransportiert wird.

5. Verfahren nach Anspruch 2, dadurch gekennzeichnet, daß ein mit einem Diaphragma überzogenes Entmetallisierungssubstrat auf der Transportbahn durch die Vorrichtung transportiert wird und dabei diejenigen Bürstenelektroden zum Entfernen von angelagertem Metall elektrisch umgepolt werden, an denen das Entmetallisierungssubstrat vorbeitransportiert wird.

6. Verfahren nach einem der Ansprüche 4 und 5, dadurch gekennzeichnet, daß das Entmetallisierungssubstrat gegenüber den umgepolten Bürstenelektroden kathodisch polarisiert wird.

7. Verfahren nach einem der Ansprüche 4 bis 6, dadurch gekennzeichnet, daß das Entmetallisierungssubstrat auf einer Endlosbahn in der Vorrichtung befördert wird, wobei das Substrat auf einem Teil der Bahn zur Entmetallisierung der Bürstenelektroden geführt wird und auf einem anderen Teil selbst wieder entmetallisiert wird.

8. Verfahren nach einem der Ansprüche 3 bis 7, dadurch gekennzeichnet, daß an den Bürstenelektroden eine hohe Stromdichte eingestellt wird, wenn diese umgepolt sind.

9. Verfahren nach Anspruch 2, dadurch gekennzeichnet, daß die Bürstenelektroden von dem angelagerten Metall durch Entfernen der Bürstenelektroden aus der Vorrichtung und nachfolgendes chemisches oder elektrochemisches Abätzen des Metalls von den Bürstenelektroden wieder befreit werden.

10. Vorrichtung zum elektrochemischen Behandeln von elektrisch gegeneinander isolierten elektrisch leitfähigen Bereichen auf Behandungsgut mittels einer Behandlungsflüssigkeit
a. mit Einrichtungen zum Transport des Gutes auf einer Transportbahn durch die Vorrichtung,
b. mit weiteren Einrichtungen zum Führen oder Aufnehmen der Behandlungsflüssigkeit, die so angeordnet sind, daß das Gut mit der Behandlungsflüssigkeit zumindest teilweise in Kontakt kommt,
c. ferner mit stationären Bürstenelektroden, die so angeordnet sind, daß sie während des Transportes des Gutes auf der Transportbahn mit allen elektrisch leitfähigen Bereichen zumindest nacheinander in elektrischen Kontakt gebracht werden können, während die Bereiche auch mit der Behandlungsflüssigkeit in Kontakt stehen,
d. mit Gegenelektroden, die so in der Nähe der Transportbahn angeordnet sind, daß ein elektrischer Strom zwischen den elektrisch leitfähigen Bereichen und den Gegenelektroden fließen kann und
e. mit einer Stromquelle und elektrischen Verbindungen zwischen der Stromquelle und den Elektroden zur Stromversorgung der Elektroden,
dadurch gekennzeichnet, daß
f. zwischen den Bürstenelektroden (4,10,12,21) und den Gegenelektroden (8,11,13) jeweils elektrisch isolierende Trennmittel (5,16) angeordnet sind, um einen direkten Stromfluß zwischen den Gegenelektroden und den Bürstenelektroden zu verhindern.

11. Vorrichtung nach Anspruch 10, dadurch gekennzeichnet, daß die Bürstenelektroden (4,10,12,21) und die Gegenelektroden (8,11,13) an beiden Seiten der Transportbahn angeordnet sind.

12. Vorrichtung nach einem der Ansprüche 10 und 11, gekennzeichnet durch weitere Einrichtungen (15,26) zur zeitweisen elektrischen Umpolung zumindest einzelner Bürstenelektroden (4,10,12,21) sowie Einrichtungen (14) zum Abheben der umgepolten Bürstenelektroden von der Transportbahn.

13. Vorrichtung nach einem der Ansprüche 10 bis 13, dadurch gekennzeichnet, daß die Bürstenelektroden (4,10,12,21) in Form von parallel zueinander ausgerichteten Reihen ausgebildet sind, die in einem Winkel größer als Null zur Transportrichtung (22) des Behandlungsgutes (1,23) auf der als Transportebene ausgebildeten Transportbahn und parallel zu dieser angeordnet sind.

14. Vorrichtung nach Anspruch 13, gekennzeichnet durch Einrichtungen (14), mit der diejenigen Reihen von der Transportebene abgehoben werden können, an denen ein Entmetallisierungssubstrat (24) in der Transportebene vorbeitransportiert wird.

15. Vorrichtung nach Anspruch 14, gekennzeichnet durch eine Steuerung zur Verfolgung des Entmetallisierungssubstrats (24) durch die Vorrichtung und zur Ansteuerung der Einrichtungen zum Abheben (14) und Umpolen (15,26) der Bürstenelektroden (4,10,12,21).

16. Vorrichtung nach einem der Ansprüche 10 bis 15, gekennzeichnet durch mindestens zwei Stromquellen (7,27,28), von denen eine zum Metallisieren des Behandlungsgutes (1,23) und eine andere zum Entmetallisieren der Bürstenelektroden (4,10,12,21) dient.

17. Vorrichtung nach einem der Ansprüche 10 bis 16, dadurch gekennzeichnet, daß die Gegenelektroden (8,11,13) zwischen auf einer Seite des Behandlungsgutes (1,23) nebeneinanderliegend angeordneten Bürstenelektroden (4,10,12,21) angeordnet sind.

18. Vorrichtung nach Anspruch 10, dadurch gekennzeichnet, daß die Bürstenelektroden (4,10,12,21) so ausgebildet sind, daß sie leicht austauschbar sind.

## Claims

1. Method of electrochemically treating electrically conductive regions, which are electrically insulated from one another, on items to be treated by means of a treatment fluid, wherein
a. the item to be treated is conveyed through the apparatus by means of conveyors on a transport path and is thereby, at least temporarily, brought into contact with the treatment fluid,
b. all of the electrically conductive regions on the item to be treated are brought into contact with stationary brush electrodes, supplied from a current source, at least one after the other, so that an electrical potential is applied to the electrically conductive regions, while the regions are also in contact with the treatment fluid,
c. and wherein counter-electrodes, also supplied from the current source with reversed polarity, are provided in the vicinity of the transport path and disposed in such a manner that an electric current can flow between the electrically conductive regions and the counter-electrodes,
characterised in that
d. electrically insulating separating means are respectively disposed between the brush electrodes and the counter-electrodes in order to prevent a direct flow of current between the counter-electrodes and the brush electrodes.

2. Method according to claim 1, characterised in that the brush electrodes are stripped again of metal accumulated during the treatment.

3. Method according to claim 2, characterised in that, in order to remove accumulated metal, individual brush electrodes are lifted off the transport path and thereby electrically pole-reversed.

4. Method according to claim 3, characterised in that a deplating substrate is conveyed on the transport path through the apparatus, and a spacing is formed between the transport path and the brush electrodes past which the deplating substrate is conveyed, those brush electrodes thereby being pole-reversed.

5. Method according to claim 2, characterised in that a deplating substrate, coated with a membrane, is conveyed on the transport path through the apparatus and, in order to remove accumulated metal, those brush electrodes, past which the deplating substrate is conveyed, are thereby electrically pole-reversed.

6. Method according to one of claims 4 and 5, characterised in that the deplating substrate is cathodically polarised opposite to the pole-reversed brush electrodes.

7. Method according to one of claims 4 to 6, characterised in that the deplating substrate is conveyed on an endless belt in the apparatus, tne substrate being guided on a portion of the pathfor deplating the brush electrodes and being itself deplated again on a different portion.

8. Method according to one of claims 3 to 7, characterised in that a high current density is set at the brush electrodes when said electrodes are pole-reversed.

9. Method according to claim 2, characterised in that the brush electrodes are stripped again of the accumulated metal by removing the brush electrodes from the apparatus and by subsequently chemically or electrochemically etching the metal from the brush electrodes.

10. Apparatus for electrochemically treating electrically conductive regions, which are electrically insulated from one another, on items to be treated by means of a treatment fluid, said apparatus
a. having means for conveying the item on a transport path through the apparatus,
b. having additional means for guiding or accommodating the treatment fluid, which means are so disposed that the item, at least partially, comes into contact with the treatment fluid,
c. also having stationary brush electrodes, which are so disposed that, during the conveyance of the item on the transport path, they can be brought into electrical contact with all of the electrically conductive regions, at least one after the other, while the regions are also in contact with the treatment fluid,
d. having counter-electrodes, which are disposed in the vicinity of the transport path in such a manner that an electric current can flow between the electrically conductive regions and the counter-electrodes, and
e. having a current source and electrical connections between the current source and the electrodes for supplying current to the electrodes,
characterised in that
f. electrically insulating separating means (5,16) are respectively disposed between the brush electrodes (4,10,12,21) and the counter-electrodes (8,11,13), in order to prevent a direct flow of current between the counter-electrodes and the brush electrodes.

11. Apparatus according to claim 10, characterised in that the brush electrodes (4,10,12,21) and the counter-electrodes (8,11,13) are disposed on both sides of the transport path.

12. Apparatus according to one of claims 10 and 11, characterised by additional means (15,26) for the temporary electrical pole-reversal of at least individual brush electrodes (4,10,12,21) as well as means (14) for lifting the pole-reversed brush electrodes off the transport path.

13. Apparatus according to one of claims 10 to 13, characterised in that the brush electrodes (4,10,12,21) are provided in rows, which are orientated parallel to one another and are disposed at an angle greater than zero relative to the direction of conveyance (22) of the item to be treated (1,23) on the transport path, which is configured as a conveying plane, and parallel to said transport path,

14. Apparatus according to claim 13, characterised by means (14), whereby those rows, past which a deplating substrate (24) is conveyed in the conveying plane, can be lifted off the conveying plane.

15. Apparatus according to claim 14, characterised by a control unit for tracking the deplating substrate (24) through the apparatus and for actuating the lifting-off means (14) and pole-reversal means (15,26) for the brush electrodes (4,10,12,21).

16. Apparatus according to one of claims 10 to 15, characterised by at least two current sources (7,27,28), of which one serves to plate the item to be treated (1,23), and another serves to deplate the brush electrodes (4,10,12,21).

17. Apparatus according to one of claims 10 to 16, characterised in that the counter-electrodes (8,11,13) are disposed between brush electrodes (4,10,12, 21), which are disposed adjacent one another on one side of the item to be treated (1,23).

18. Apparatus according to claim 10, characterised in that the brush electrodes (4,10,12,21) are so configured that they are easily replaceable.

## Revendications

1. Procédé de traitement électrochimique de zones électroconductrices isolées électriquement les unes des autres, sur un élément à traiter, au moyen d'un liquide de traitement, dans lequel
a. l'élément à traiter est acheminé à travers le dispositif sur une voie de transport au moyen d'installations de transport, et est en l'occurrence mis en contact avec le liquide de traitement au moins temporairement,
b. toutes les zones électroconductrices sur l'élément à traiter sont mises en contact au moins l'une après l'autre avec des électrodes-balais fixes, alimentées par une source de courant, de telle sorte qu'il existe un potentiel électrique au niveau des zones électroconductrices, tandis que les zones se trouvent également en contact avec le liquide de traitement,
c. dans lequel sont en outre prévues, à proximité de la voie de transport, des contre-électrodes également alimentées par la source de courant avec une polarité inverse, ces contre-électrodes étant disposées de telle sorte qu'un courant électrique puisse circuler entre les zones électroconductrices et les contre-électrodes,
caractérisé en ce que
d. entre les électrodes-balais et les contre-électrodes sont respectivement disposés des moyens séparateurs assurant une isolation électrique, afin d'empêcher un passage de courant entre les contre-électrodes et les électrodes-balais.

2. Procédé selon la revendication 1, caractérisé en ce que les électrodes-balais sont de nouveau débarrassées du métal déposé lors du traitement.

3. Procédé selon la revendication 2, caractérisé en ce que, pour éliminer le métal déposé, des électrodes-balais individuelles sont retirées de la voie de transport et subissent alors une inversion de leur polarité électrique.

4. Procédé selon la revendication 3. caractérisé en ce qu'un substrat de démétallisation est transporté sur la voie de transport à travers le dispositif et une distance est établie entre la voie de transport et les différentes électrodes-balais, ce qui entraîne une inversion de la polarité des électrodes-balais devant lesquelles passe le substrat de démétallisation.

5. Procédé selon la revendication 2, caractérisé en ce qu'un substrat de démétallisation recouvert d'un diaphragme est transporté sur la voie de transport à travers le dispositif, ce qui entraîne une inversion de la polarité électrique des différents électrodes-balais devant lesquelles passe le substrat de démétallisation, afin d'éliminer le métal déposé.

6. Procédé selon l'une des revendications 4 et 5, caractérisé en ce que le substrat de démétallisation est polarisé de manière cathodique par rapport aux électrodes-balais dont la polarité a été inversée.

7. Procédé selon l'une quelconque des revendications 4 à 6, caractérisé en ce que le substrat de démétallisation est transporté sur une voie sans fin dans le dispositif, le substrat étant acheminé sur un tronçon de voie afin de démétalliser les électrodes-balais et étant de nouveau démétallisé sur un autre tronçon.

8. Procédé selon l'une quelconque des revendications 3 à 7, caractérisé en ce qu'une densité de courant élevée est établie au niveau des électrodes-balais, lorsque la polarité de ces dernières est inversée.

9. Procédé selon la revendication 2, caractérisé en ce que les électrodes-balais sont de nouveau débarrassées du métal déposé en éloignant les électrodes-balais de dispositif ou en corrodant par voie chimique oux électrochimique le métal des électrodes-balais.

10. Dispositif de traitement électrochimique de zones électroconductrices isolées électriquement les unes des autres. sur un élément à traiter, au moyen d'un liquide de traitement. présentant
a. des installations de transport de l'élément sur une voie de transport à travers le dispositif,
b. d'autres installations destinées à l'acheminement ou à la réception du liquide de traitement, ces installations étant disposées de telle sorte que l'élément vienne au contact du liquide de traitement au moins temporairement
c. en outre des électrodes-balais fixes disposées de telle sorte que, durant le transport de l'élément sur la voie de transport, ces électrodes soient mises en contact au moins l'une après l'autre avec toutes les zones électroconductrices, tandis que les zones sont également en contact avec le liquide de traitement,
d. des contre-électrodes, qui sont disposées à proximité de la voie de transport de telle sorte qu'un courant électrique puisse circuler entre les zones électroconductrices et les contre-électrodes,
e. une source de courant et des connexions entre la source de courant et les électrodes afin d'alimenter les électrodes en courant,
caractérisé en ce que
f. entre les électrodes-balais (4, 10, 12, 21) et les contre-électrodes (8, 11, 13) sont disposés respectivement des moyens séparateurs isolants électriquement, afin d'empêcher un passage de courant direct entre les contre-électrodes et les électrodes-balais.

11. Dispositif selon la revendication 10, caractérisé en ce que les électrodes-balais (4, 10, 12, 21) et les contre-électrodes (8, 11, 13) sont disposées des deux côtés de la voie de transport.

12. Dispositif selon l'une des revendications 10 et 11, caractérisé par d'autres installations (15, 26) destinées à inverser temporairement la polarité électrique au moins d'électrodes-balais individuelles (4, 10, 12, 21), ainsi que par des installations (14) destinées à retirer de la voie de transport les électrodes-balais, ayant subi une inversion de la polarité.

13. Dispositif selon l'une quelconque des revendications 10 a 13, caractérisé en ce que les électrodes-balais (4, 10, 12, 21) sont conçues de manière à former des rangées parallèles les unes aux autres, qui sont disposées en formant un angle supérieur à zéro par rapport à la direction de transport (22) de l'élément à traiter (1, 23) sur la voie de transport constituant un plan de transport et sont parallèles à celui-ci.

14. Dispositif selon la revendication 13, caractérisé par des installations (14) permettant de retirer les différentes rangées du plan de transport, devant lesquelles passe un substrat de démétallisation (24) dans le plan de transport.

15. Dispositif selon la revendication 14, caractérisé par une commande permettant de suivre le substrat de démétallisation (24) tout au long du dispositif et de commander les installations de retrait (14) et d'inversion de la polarité (15, 26) des électrodes-balais (4, 10, 12, 21).

16. Dispositif selon l'une quelconque des revendications 10 à 15, caractérisé par au moins deux sources de courant (7, 27, 28), parmi lesquelles une source de courant sert à démétalliser l'élément à traiter (1, 23) et une autre sert à démétalliser les électrodes-balais (4, 10, 12, 21).

17. Dispositif selon l'une quelconque des revendications 10 à 16, caractérisé en ce que les contre-électrodes (8, 11, 13) sont disposées entre les électrodes-balais (4, 10, 12, 21) juxtaposées d'un côté de l'élément à traiter (1, 23).

18. Dispositif selon la revendication 10, caractérisé en ce que les électrodes-balais (4, 10, 12, 21) sont conçues de manière à pouvoir être interverties facilement.
